# DEMANDE DE BREVET EUROPEEN

(11) **EP 4 730 952 A1**
(43) Date de publication de la demande: **22.04.2026**
(21) Numéro de dépôt: 25208801.8
(22) Date de dépôt: 15.10.2025
(51) Int. Cl.: H10D 30/66, H10D 30/01, H10D 62/10, H10D 62/85, H10D 64/23, H10P 14/20

(54) **PROCÉDÉ DE FABRICATION DE TRANSISTORS VERTICAUX À BASE DE GAN**

(30) Priorité: 16.10.2024 FR 2411188
(71) Demandeur: Commissariat à l'Energie Atomique et aux Energies Alternatives, 75015 Paris (FR)
(72) Inventeur: BUCKLEY, Julien, 38054 GRENOBLE Cedex 09 (FR); CHARLES, Matthew, 38054 GRENOBLE Cedex 09 (FR); BISCARRAT, Jérôme, 38054 GRENOBLE Cedex 09 (FR); KALTSOUNIS, Thomas, 38054 GRENOBLE Cedex 09 (FR); GODIGNON, Philippe, 38054 GRENOBLE Cedex 09 (FR); EL AMRANI, Mohammed, 38054 GRENOBLE Cedex 09 (FR); PLAZA ARGUELLO, David, 38054 GRENOBLE Cedex 09 (FR); EL RAMMOUZ, Hala, 38054 GRENOBLE Cedex 09 (FR); MAURYA, Vishwajeet, 38054 GRENOBLE Cedex 09 (FR)
(74) Mandataire: Hautier IP

(57) **Abrégé**

L'invention concerne un procédé de fabrication d'au moins un transistor vertical (1a, 1b). On fournit tout d'abord un substrat (10) présentant une face supérieure (11), on réalise une épitaxie localisée de GaN sur le substrat de sorte à former au moins un îlot (100a, 100b), puis, au niveau de chaque îlot, on forme au moins un motif électriquement conducteur dit grille (200) et au moins un contact électriquement conducteur dit contact source (300). On retire le substrat (10), puis on forme contre la face inférieure (102a, 102b) de l'au moins un îlot une couche électriquement conductrice (400) formant un drain (400), formant ainsi au moins un transistor vertical (1a, 1b).

## Description

### DOMAINE TECHNIQUE

La présente invention concerne le domaine des dispositifs microélectroniques, notamment les composants à base de GaN. Elle trouve par exemple pour application particulièrement avantageuse le domaine de l'électronique de puissance.

### ETAT DE LA TECHNIQUE

Il existe de nombreuses architectures de transistors, parmi lesquelles les transistors verticaux. Les propriétés de ces transistors sont aujourd'hui particulièrement exploitées dans les applications d'électronique de puissance.

Les transistors verticaux à base de GaN sont typiquement fabriqués par épitaxie à partir de substrats GaN. Cependant, les substrats GaN disponibles dans l'industrie sont de faible diamètre. Les procédés actuels de fabrication de transistors verticaux GaN sur substrat GaN ne permettent donc pas de fabriquer simultanément une quantité de transistors comparable à ce qui est réalisé sur des substrats de plus grand diamètre (substrats silicium typiquement). Ces procédés sont par ailleurs très coûteux du fait du prix élevé des substrats GaN.

Un objectif de la présente invention est ainsi de proposer un procédé de fabrication de transistors verticaux à base de GaN résolvant au moins certains des problèmes évoqués ci-dessus.

### RESUME

Pour atteindre cet objectif, selon un mode de réalisation on prévoit un procédé de fabrication d'au moins un transistor vertical comprenant les étapes suivantes :
- fournir un substrat présentant une face supérieure, typiquement un substrat silicium,
- réaliser une épitaxie localisée de nitrure de gallium (GaN) sur la face supérieure du substrat, de sorte à former au moins un îlot à base de GaN, chaque îlot comprenant une première couche à base de GaN dopé d'un premier type pris parmi un dopage de type n et un dopage de type p, et une deuxième couche à base de GaN dopé de l'autre type surmontant directement la première couche, chaque îlot présentant une face, dite inférieure, tournée au regard de la face supérieure du substrat,
- au niveau de chaque îlot, former au moins une grille en contact avec la première couche et avec la deuxième couche, l'au moins une grille comprenant un motif électriquement conducteur, et former au moins un contact électriquement conducteur dit contact source au contact de la deuxième couche,
- former une couche électriquement conductrice formant un drain, le drain étant relié électriquement à la face inférieure de chaque îlot, formant ainsi au moins un transistor vertical.

Ainsi, le procédé selon l'invention permet d'initier la formation des transistors sur un substrat de grande dimension et peu coûteux, tel qu'un substrat silicium. On évite ainsi d'avoir recours à un substrat GaN coûteux et de faible dimension. Les étapes de formation des grilles et contacts sources peuvent être réalisées alors que les îlots reposent sur le substrat, ou bien après retrait de ce substrat. La formation du drain en face arrière nécessite simplement de retirer préalablement le substrat par meulage et/ou CMP et/ou gravure, ou bien de réaliser des interconnexions métalliques dans le substrat, ce qui est tout à fait raisonnable dans le cas d'un substrat silicium. On obtient ainsi des transistors GaN entièrement verticaux sans avoir à sacrifier un substrat GaN.

L'épitaxie locale du GaN peut en outre permettre de former des îlots de hauteur allant jusqu'à 10 µm voire 20 µm. Grâce à cela, les transistors formés par le procédé peuvent supporter des tensions aussi élevées que 1200V voire 2200V.

Par ailleurs, le procédé permet de fabriquer efficacement des transistors verticaux avec un très fort taux de couverture du substrat. Pour des îlots hexagonaux par exemple, la surface perdue du fait des écarts entre îlots est comprise entre 5 à 10% de la surface totale, ce qui est très faible.

Ainsi, le procédé selon l'invention permet une fabrication efficace, à grande échelle et peu coûteuse de transistors verticaux à base de GaN. Les transistors fabriqués sont par ailleurs très compacts et robustes.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1A à 1F illustrent un premier mode de réalisation du procédé selon l'invention, dans lequel les grilles des transistors sont formées dans les îlots de GaN.
Les figures 1E et 1F illustrent un exemple dans lequel le substrat est retiré et le drain est formé au contact direct des îlots.
Les figures 1G et 1H illustrent un exemple dans lequel des interconnexions métalliques sont formées dans le substrat et le drain est formé au contact de ces interconnexions.
Les figures 2A à 2F illustrent un deuxième mode de réalisation du procédé selon l'invention, dans lequel les grilles des transistors sont formées dans les îlots de GaN.
Les figures 3A à 3D illustrent un troisième mode de réalisation du procédé selon l'invention, dans lequel les grilles des transistors sont formées contre les îlots de GaN.
Les figures 4A à 4C sont des images obtenues par microscopie électronique à balayage (MEB) d'îlots de GaN crus par épitaxie localisée.
La figure 4B est un agrandissement de la figure 4A.
La figure 4C est un agrandissement de la figure 4B.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple avantageux, le substrat est à base de silicium. Les substrats silicium sont en effet peu coûteux et sont très bien adaptés à la réalisation d'épitaxies localisées de GaN.

Selon un exemple préféré, chaque îlot présente une hauteur h₁₀₀ supérieure ou égale à 10 µm, de préférence supérieure ou égale à 20 µm, h₁₀₀ étant mesurée dans une direction perpendiculaire à un plan dans lequel la face supérieure du substrat s'étend principalement.

Selon un mode de réalisation, l'étape de formation du drain comprend les étapes suivantes :
- après formation de l'au moins un îlot, retirer le substrat, puis
- former le drain contre la face inférieure de l'au moins un îlot.

Selon un mode de réalisation, l'étape de formation du drain comprend les étapes suivantes :
- pour chaque îlot, former au moins une interconnexion métallique traversant le substrat et débouchant sur ledit îlot,
- former le drain contre une face inférieure du substrat opposée à sa face supérieure, le drain se trouvant en contact avec l'au moins une interconnexion métallique.

Selon un mode de réalisation avantageux, la formation de l'au moins une grille comprend les étapes suivantes :
- graver au moins une ouverture s'étendant depuis la face supérieure de l'au moins un îlot, l'ouverture traversant entièrement la deuxième couche et traversant au moins partiellement la première couche,
- former l'au moins une grille dans l'au moins une ouverture.

Du fait du positionnement de la grille (ou les grilles) au niveau de la face supérieure des îlots, ce mode de réalisation autorise une forte densité de transistors.

Selon un mode de réalisation avantageux, l'étape d'épitaxie comprend l'étape suivante : former par épitaxie la première couche et la deuxième couche au travers d'un masque, de manière à définir au moins une ouverture s'étendant depuis une face supérieure de l'au moins un îlot, l'ouverture traversant la deuxième couche et traversant au moins partiellement la première couche, et l'au moins une grille est formée dans ladite au moins une ouverture. Ce mode de réalisation ne nécessite pas la réalisation d'une gravure dans le ou les îlots de GaN pour former la ou les grilles, ce qui évite l'introduction de charges dans les îlots. Ces charges sont en effet néfastes au bon fonctionnement des transistors car elles peuvent provoquer une hystérésis lors d'une commutation. Du fait du positionnement de la grille (ou les grilles) au niveau de la face supérieure des îlots, ce mode de réalisation autorise par ailleurs une forte densité de transistors.

Selon un exemple préféré, une pluralité de grilles est formée au contact de la première couche et de la deuxième couche d'un même îlot. La présence d'une pluralité de grilles permet d'augmenter la puissance du transistor formé.

Selon un exemple préféré, une pluralité de contacts sources est formée en contact de la deuxième couche et, en projection dans un plan dans lequel la face supérieure du substrat s'étend principalement, les grilles et les contacts sources se trouvent en alternance.

Selon un mode de réalisation avantageux, au moins deux îlots et deux transistors sont formés, et la grille formée au niveau du premier îlot et celle formée au niveau du deuxième îlot sont en continuité électrique et forment une grille commune aux deux transistors.

Selon un exemple, la grille commune aux deux transistors s'étend entre un flanc latéral du premier îlot et un flanc latéral du deuxième îlot. Ce mode de réalisation ne nécessite pas la réalisation d'une gravure dans le ou les îlots de GaN pour former la ou les grilles, ce qui évite l'introduction de charges dans les îlots. Ces charges sont en effet néfastes au bon fonctionnement des transistors car elles peuvent provoquer une hystérésis lors d'une commutation.

Selon un exemple, le drain est à base de cuivre. Les propriétés du cuivre permettent en effet de conférer au(x) transistor(s) des performances thermiques et électriques optimales.

Selon un exemple avantageux, l'étape de retrait du substrat est réalisée avant la formation de la grille et de l'au moins un contact source au niveau de chaque îlot, et éventuellement avant la formation de la première couche et de la deuxième couche. Le retrait du substrat en début de procédé permet de diminuer la contrainte dans les différentes couches et notamment dans les îlots de GaN pendant le procédé. Cela permet de limiter la quantité de défauts structurels dans l'empilement et donc d'améliorer les performances des transistors.

Selon un exemple alternatif, l'étape de retrait du substrat est réalisée après la formation de la grille et de l'au moins un contact source au niveau de chaque îlot.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant, soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. La sélectivité entre A et B est notée SA:B.

Deux éléments sont dits « reliés électriquement » lorsqu'ils sont chacun en contact avec un même élément de connexion électrique continu présentant une conduction électrique de préférence supérieure à 10⁷ S/m.

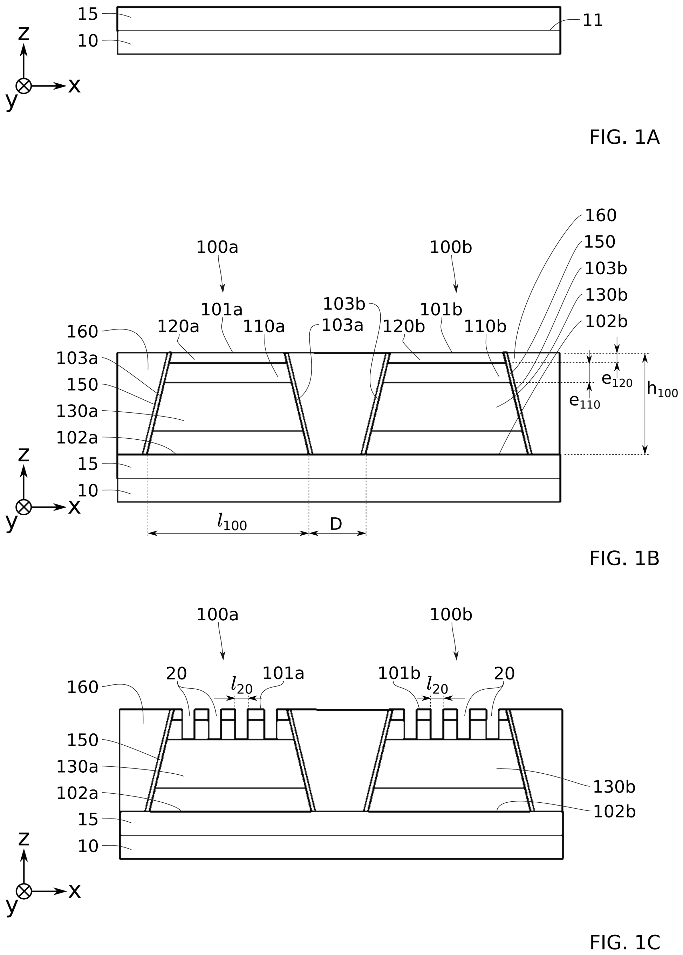

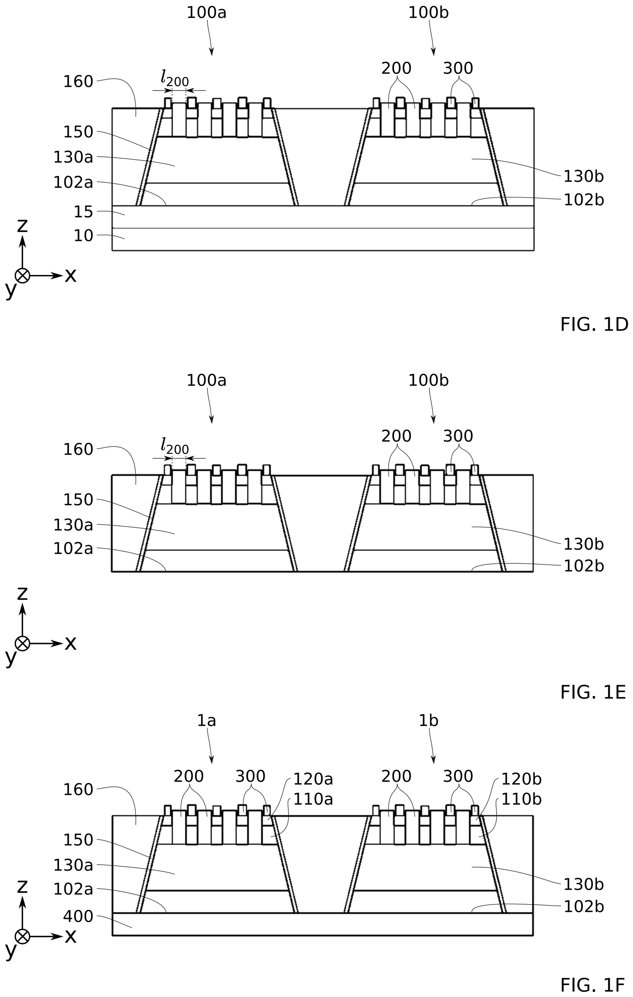

Un repère, de préférence orthonormé, comprenant les axes X, Y, Z est représenté en figure 1A. Ce repère est applicable par extension aux autres figures. La direction Z pourra être désignée « direction d'empilement ».

Dans la présente demande de brevet, on parlera préférentiellement d'épaisseur pour une couche et de hauteur pour une structure ou un dispositif. La hauteur est prise perpendiculairement au plan longitudinal XY. L'épaisseur est prise selon une direction normale au plan d'extension principal de la couche. Ainsi, une couche présente typiquement une épaisseur selon Z, lorsqu'elle s'étend principalement le long du plan longitudinal XY, et un élément en saillie, par exemple une tranchée d'isolation, présente une hauteur selon Z. Les termes relatifs « sur », « sous », « dessus », « dessous », « sous-jacent » se réfèrent préférentiellement à des positions prises selon la direction Z.

Les termes « sensiblement », « environ », « de l'ordre de » signifient « à 10% près, de préférence à 5% près ».

Un premier mode de réalisation du procédé selon l'invention va maintenant être décrit en référence aux figures 1A à 1F. Ces figures illustrent la formation simultanée de deux transistors 1a, 1b, mais il est entendu qu'un plus grand nombre de transistors peut être fabriqué simultanément par le procédé selon l'invention.

La figure 1A illustre la fourniture d'un substrat 10. Ce substrat 10 est typiquement à base de silicium. Il présente une face supérieure 11 s'étendant principalement dans un plan XY pouvant être désigné plan longitudinal XY. Ce plan est défini par une première direction X et une deuxième direction Y. Le substrat 10 présente en outre une face inférieure 12 opposée à sa face supérieure 11.

Avantageusement, des couches tampons 15 sont déposées sur la face supérieure 11 du substrat 10. Ces couches tampons 15 peuvent par exemple chacune être à base de l'un des matériaux suivants : AIN, AlGaN, BN.

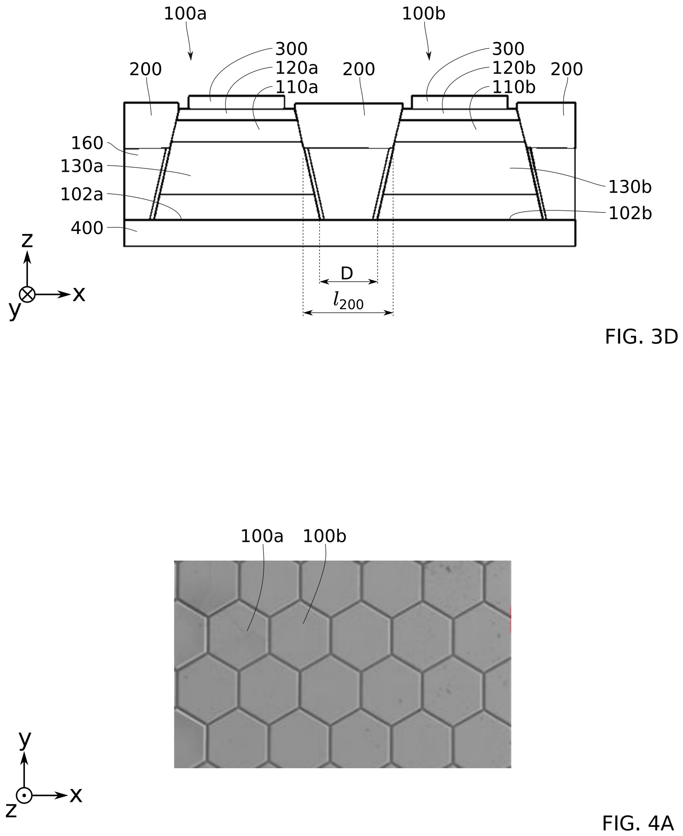

Comme illustré à la figure 1B, des îlots 100a, 100b à base de GaN sont ensuite crus localement par épitaxie sur la face supérieure 11 du substrat 10. Typiquement, ces îlots 100a, 100b sont crus à partir des couches tampons 15. La figure 4A illustre le résultat expérimental de cette étape : elle constitue une vue de dessus obtenue par MEB d'un ensemble d'îlots crus par épitaxie localisée sur un substrat silicium. On peut notamment apprécier sur cette image qu'un grand nombre d'îlots peuvent être crus simultanément par épitaxie localisée.

Les îlots 100a, 100b sont séparés les uns des autres. Ainsi, de préférence, on ne trouve aucune couche continue résiduelle de GaN sur la face supérieure 11 du substrat 10 (à l'exception d'éventuelles couches tampons pouvant comprendre du GaN).

Les îlots 100a, 100b présentent chacun une face inférieure 102a, 102b se trouvant en regard de la face supérieure 11 du substrat 10, et typiquement en contact avec les couches tampons 15. Ils présentent par ailleurs chacun une face supérieure 101a, 101b opposée à la face inférieure 102a, 102b.

L'étape d'épitaxie des îlots 100a, 100b de GaN est avantageusement configurée pour former des couches de GaN au sein de chaque îlots 100a, 100b présentant des dopages différents. Selon un exemple avantageux, les îlots 100a, 100b comprennent les couches suivantes, depuis les faces inférieures 102a, 102b des îlots 100a, 100b vers leurs faces supérieures 101a, 101b : une couche de GaN dopé n+, une couche de GaN dopée n-, pouvant être désignée couche de migration ou drift layer 130a, 130b, une couche de GaN dopé p, dite première couche 110a, 110b, et une couche de GaN dopé n+, dite deuxième couche 120a, 120b. Selon un exemple alternatif, les dopages des couches sont inversés et la première couche 110a, 110b est dopée n+ et la deuxième couche 120a, 120b est dopée p.

De façon parfaitement classique, le dopant des couches dopées n peut être le silicium (Si) et le dopant des couches dopées p le magnésium (Mg).

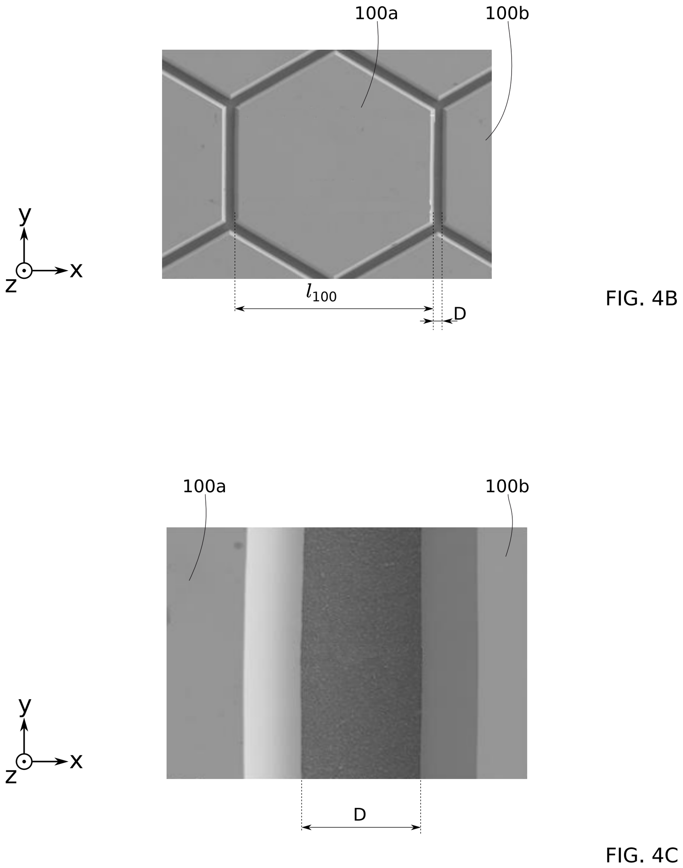

Les îlots 100a, 100b présentent une dimension caractéristique dans le plan XY notée I₁₀₀. En projection dans le plan XY, les îlots 100a, 100b présentent typiquement chacun une forme hexagonale, comme cela peut être observé sur la figure 4A. Dans ce cas, la dimension caractéristique I₁₀₀ correspond à la distance entre deux flancs de l'îlots 100a, 100b se faisant face. Sur la figure 4B, I₁₀₀ est par exemple mesurée selon la première direction X. I₁₀₀ est de préférence supérieure à 100 µm, et de préférence inférieure ou égale à 200 µm.

Les flancs latéraux 103a, 103b des îlots 100a, 100b sont typiquement inclinés par rapport à la direction d'empilement Z, comme illustré sur les figures. I₁₀₀ est alors mesurée à la base des îlots 100a, 100b, au niveau de leur face inférieure 102a, 102b.

Les îlots 100a, 100b présentent une hauteur h₁₀₀ mesurée selon la direction Z (également désignée direction d'empilement Z) perpendiculaire au plan longitudinal XY. La hauteur h₁₀₀ est de préférence supérieure à 10 µm voire 20 µm. Par ailleurs, la première couche 110a, 110b et la deuxième couche 120a, 120b présentent respectivement une épaisseur e₁₁₀ et une épaisseur e₁₂₀ selon la direction d'empilement Z. Typiquement, e₁₁₀ est compris entre 200 nm et 1500 nm. Typiquement, e₁₂₀ est compris entre 20 nm et 300 nm.

Dans le plan longitudinal XY, les îlots 100a, 100b sont séparés d'une distance D (prise selon la première direction X sur les figures 1B, 4B et 4C). D est mesurée au pied des îlots 100a, 100b, c'est-à-dire à la hauteur selon Z à laquelle se trouve les faces inférieures 102a, 102b des îlots 100a, 100b. La distance D est typiquement supérieure à 5 µm. La distance D est de préférence inférieure à 20 µm voire inférieure à 15 µm, voire à 10 µm. D est typiquement comprise entre 10 et 15 µm. Cela permet de fabriquer des transistors avec une meilleure densité. Elle est par exemple sensiblement égale à 8 µm.

Les valeurs numériques données ci-dessus sont également valables pour les deuxièmes et troisièmes modes de réalisation qui seront décrits plus avant.

Comme cela est également illustré sur la figure 1B, les flancs latéraux 103a, 103b des îlots 100a, 100b sont avantageusement recouverts d'une couche de passivation 150. La couche de passivation 150 est par exemple à base d'alumine ou de SiN.

Les espaces laissés vides entre les îlots 100a, 100b sont de préférence remplis par une couche de remplissage 160 à base d'un matériau diélectrique, par exemple à base de silice ou de tetraethyl orthosilicate (TEOS). Le dépôt de la couche de remplissage 160 peut se faire par dépôt subatomique chimique en phase vapeur (couramment désigné SACVD, de l'anglais « sub-atomical chemical vapor deposition »). Avantageusement, ce dépôt se fait selon une méthode faible contrainte (« low stress » en anglais).

Le dépôt de la couche de remplissage 160 peut être suivi d'une étape de planarisation au niveau de la face supérieure 101a, 101b des îlots 100a, 100b.

Une étape de gravure est ensuite réalisée à partir des faces supérieures 101a, 101b des îlots 100a, 100b. Cette étape de gravure est configurée pour former au moins une ouverture 20, et de préférence une pluralité d'ouvertures 20, dans chaque îlot 100a, 100b. Chaque ouverture 20 traverse entièrement la deuxième couche 120a, 120b et au moins partiellement, de préférence entièrement, la première couche 110a, 110b. Comme cela apparaîtra plus avant, les dimensions des ouvertures 20 conditionnent celles des grilles 200 des transistors 1a, 1b. Les ouvertures 20 présentent par exemple une largeur I₂₀ selon la première direction X, avec I₂₀ comprise entre 100 nm et 4000 nm. Selon la deuxième direction Y, les ouvertures 20 peuvent traverser entièrement les îlots 100a, 100b. Selon un mode de réalisation alternatif, les ouvertures 20 présentent, en projection dans le plan transversal XY, une forme hexagonale. I₂₀ correspond alors typiquement à un côté de l'hexagone.

De façon parfaitement classique, cette étape de gravure peut être réalisée par une gravure sèche au travers d'une couche de masquage.

Lors d'une étape illustrée à la figure 1D, des motifs électriquement conducteurs 200 sont formés dans les ouvertures 20. Ces motifs électriquement conducteurs font partie des grilles 200 des transistors qui seront formés en fin de procédé. La largeur I₂₀₀ des grilles 200 est sensiblement égale à la largeur I₂₀ des ouvertures 20. Il est entendu que chaque grille 200 peut également comprendre un oxyde semi-conducteur (par exemple du SiO₂), dit oxyde de grille ou diélectrique de grille. L'oxyde de grille est au contact du motif électriquement conducteur. Les oxydes de grille sont typiquement formés à cette même étape.

Par ailleurs, on forme également des contacts électriquement conducteurs dits contacts sources 300 sur la deuxième couche 120a, 120b.

Comme illustré à la figure 1E, on procède ensuite au retrait du substrat 10 et des éventuelles couches tampons 15. Ce retrait est typiquement effectué par meulage et polissage mécanochimique (couramment désigné CMP, de l'anglais « chemical-mechanical polishing »). Avantageusement, une majeure partie du retrait est effectuée par meulage et CMP, puis le retrait est finalisé par gravure sélective ou gravure au temps pour s'arrêter précisément sur la face inférieure 102a, 102b des îlots 100a, 100b.

Avantageusement, le retrait du substrat 10 et des couches tampon 15 intervient après le report des îlots 100a, 100b sur un substrat-poignée (non représenté). Ce report intervient du côté de la face supérieure 101a, 101b des îlots 100a, 100b. Le substrat-poignée est retiré après la formation du drain 400 décrite plus avant.

Le retrait du substrat 10 et des couches tampons 15 peut également intervenir plus tôt dans le procédé. Le substrat 10 peut en effet être retiré après la formation des îlots 100a, 100b (et les optionnelles formations de la couche de passivation 150 et de la couche de remplissage 160), et avant la formation des grilles 200 et contacts sources 300, entre les étapes illustrées aux figures 1B et 1C ou 1C et 1D. Cela permet de réduire les contraintes mécaniques au sein de l'empilement lors de la formation des grilles 200 et des contacts sources 300.

Après la formation des grilles 200 et des contacts sources 300, on procède à la formation d'une couche électriquement conductrice dite drain 400 au contact des faces inférieures 102a, 102b des îlots 100a, 100b. Ce drain 400 s'étend de façon continue sous les îlots 100a, 100b. Il est ainsi commun à tous les transistors 1a, 1b. La formation du drain 400 est typiquement réalisée par dépôt métallique électrochimique.

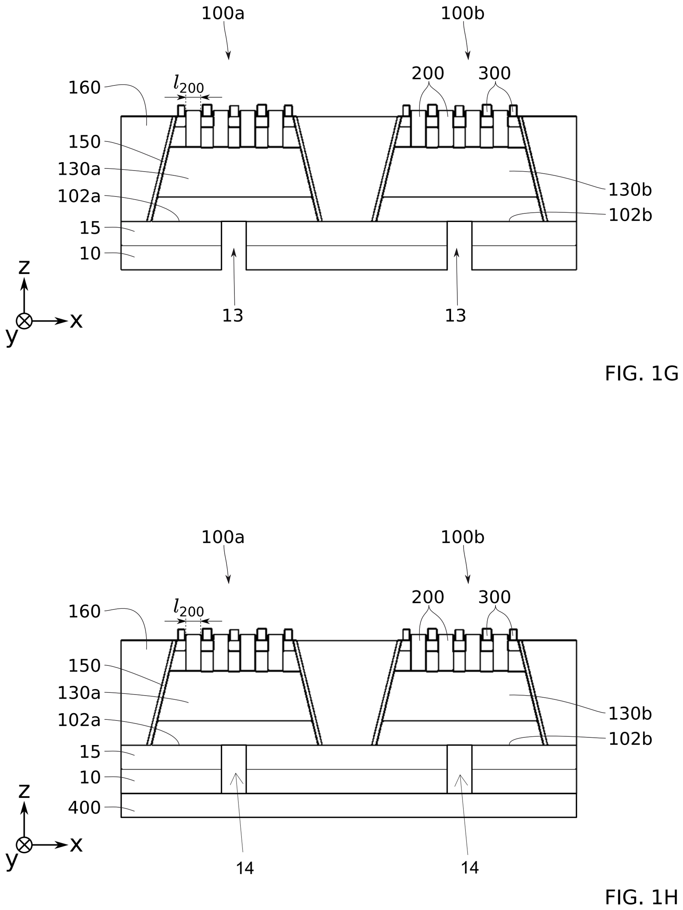

Selon un mode de réalisation alternatif illustré aux figures 1G et 1H, plutôt que de retirer le substrat 10 et les couches tampons 15, des interconnexions métalliques sont réalisées. Ainsi, il est possible, comme illustré en figure 1G, de réaliser par gravure des ouvertures traversantes 13 traversante entièrement le substrat 10 et éventuellement les couches tampons 15. Les ouvertures traversantes 13 s'étendent ainsi notamment de la face supérieure 11 à la face inférieure 12 du support. On forme au moins une ouverture traversante 13 en regard de chaque îlot 100a, 100b. Les ouvertures traversantes 13 sont typiquement formées par un procédé de photolithographie et gravure. Les ouvertures traversantes 13 sont ensuite remplies d'un matériau électriquement conducteur, typiquement un métal, de manière à former des interconnexions métalliques 14 traversant également le substrat 10 et les couches tampons 15. Le drain 400 est alors formé contre la face inférieure 12 du substrat 10 (figure 1H). Le drain 400 est formé au contact d'au moins une interconnexion métallique 14, de préférence de toutes les interconnexions métalliques 14. Les interconnexions métalliques 14 assurent la connexion électrique entre le drain 400 et les îlots 100a, 100b.

Le procédé permet ainsi de former au moins un transistor 1a, 1b, chacun formé des éléments suivants :
- Le drain 400, ou du moins une portion de ce drain 400,
- Un îlot 100a, 100b, comprenant des couches de GaN aux dopages distincts dont la première couche 110a, 110b et la deuxième couche 120a, 120b,
- Au moins une grille 200 déposée au contact de la première couche 110a, 110b et de la deuxième couche 120a, 120b de l'îlot 100a, 100b considéré,
- Au moins un contact source 300 déposé sur la deuxième couche 120.

Les différentes étapes du procédé (formation des ouvertures 20 dans les îlots 100a, 100b, formation des grilles 200, formation des contacts sources 300) sont de préférence telles qu'en projection dans le plan longitudinal XY, les grilles 200 et les contacts sources 300 se trouvent en alternance. Typiquement, chaque transistor 1a, 1b formé comprend un contact source 300 de plus que de grilles 200.

La présence d'une pluralité de grilles 200 et de contacts sources 300 au sein de chaque transistor 1a, 1b permet d'augmenter leur puissance. Avantageusement, chaque transistor 1a, 1b comprend au moins 3 grilles 200, de préférence au moins 5 grilles 200.

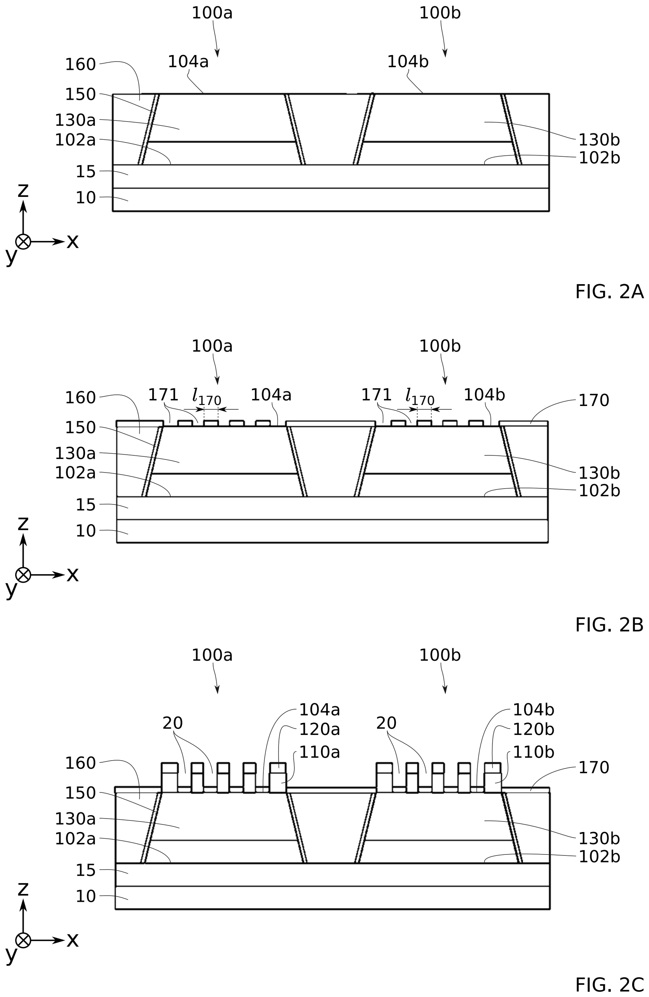

Un deuxième mode de réalisation va maintenant être décrit en référence aux figures 2A à 2F.

Le deuxième mode de réalisation peut par exemple débuter comme le premier mode de réalisation décrit ci-dessus avec la fourniture d'un substrat 10 et avantageusement de couches tampons 15, comme illustré à la figure 1A.

Ensuite, l'épitaxie des îlots 100a, 100b est débutée au-dessus de la face supérieure 11 de substrat 10, mais elle est interrompue avant la formation de la première couche 110a, 110b et de la deuxième couche 120a, 120b, comme illustré sur la figure 2B. A ce stade, les îlots 100a, 100b présentent chacun une face intermédiaire 104a, 104b opposée à leurs faces inférieures 102a, 102b.

Un masque dur 170 est ensuite formé sur les faces intermédiaires 104a, 104b des îlots 100a, 100b. Le masque dur 170 présente au moins une ouverture 171, et de préférence une pluralité d'ouvertures 171, révélant en partie les faces intermédiaires 104a, 104b des îlots 100a, 100b. Comme cela apparaîtra plus avant, les dimensions du motif défini par masque 170 conditionnent les dimensions des grilles 200 des transistors 1a, 1b. Le masque 170 peut par exemple comprendre des bandes s'étendant entre les ouvertures 171. Ces bandes de masque 170 présentent une largeur I₁₇₀ selon la première direction X, avec de préférence I₁₇₀ comprise entre 100 nm et 4000 nm. Le masque 170 peut également comprendre des ouvertures présentant une forme hexagonale. La dimension caractéristique I₁₇₀ de ces ouvertures correspond alors au côté de l'hexagone.

Comme illustré à la figure 2C, la première couche 110a, 110b et la deuxième couche 120a, 120b sont ensuite formées par épitaxie à partir de la face intermédiaire 104a, 104b, au travers des ouvertures 171 du masque 170.

De préférence, lors de cette étape d'épitaxie, la formation de la première couche 110a, 110b est précédée d'une croissance de n-GaN. Cette couche de n-GaN présente de préférence une épaisseur au moins égale à celle du diélectrique de grille.

Selon un mode de réalisation avantageux, le masque 170 est conservé après l'étape d'épitaxie. Cela permet une épaisseur supplémentaire en fond de grille qui est favorable à la tenue en champ électrique de la grille lorsque le composant est en blocage. Dans ce cas, avantageusement, l'épaisseur de la couche de n-GaN est égale à la somme de l'épaisseur du diélectrique de grille et de celle du masque 170.

Dans ce mode de réalisation, la première couche 110a, 110b et la deuxième couche 120a, 120b sont ainsi directement formées avec des ouvertures 20, à l'inverse du premier mode de réalisation où celles-ci sont formées par gravure dans la première couche 110a, 110b et dans la deuxième couche 120a, 120b. Les ouvertures 20 sont définies dans ce deuxième mode de réalisation par le masque 170.

Le masque 170 est ensuite retiré, comme l'illustre le passage de la figure 2C à la figure 2D.

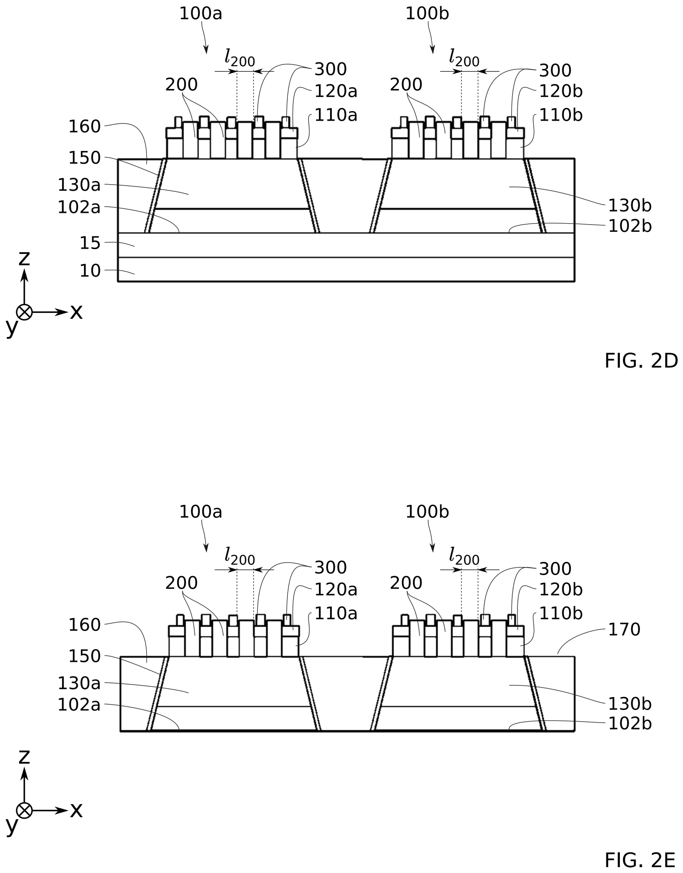

Les grilles 200 et contacts sources 300 sont ensuite formés respectivement dans les ouvertures 20 et sur la deuxième couche 120a, 120b tel que décrit précédemment dans le cadre du premier mode de réalisation (figure 2D).

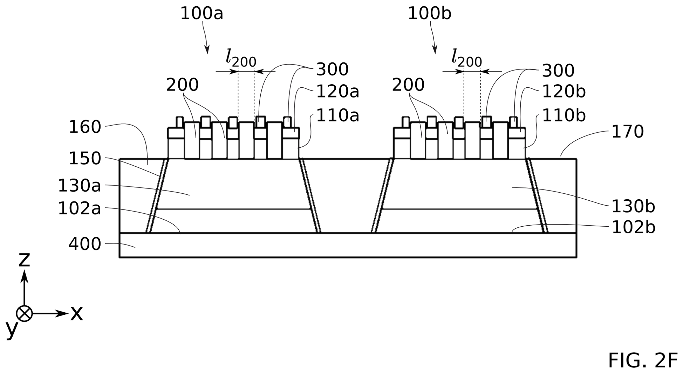

Les étapes de retrait du substrat 10 (figure 2E) et de formation du drain 400 (figure 2F) sont elles aussi réalisées de façon similaire à ce qui a été décrit en référence au premier mode de réalisation. Tout comme dans le premier mode de réalisation, il est également possible de réaliser des interconnexions métalliques dans le substrat 10 et dans les couches tampons 15 et de former le drain au contact de la face inférieure 12 du substrat 10.

Le procédé permet ainsi de former au moins un transistor 1a, 1b, chacun formé des éléments suivants :
- Le drain 400, ou du moins une portion de ce drain 400,
- Un îlot 100a, 100b, comprenant des couches de GaN aux dopages distincts dont la première couche 110a, 110b et la deuxième couche 120a, 120b,
- Au moins une grille 200 déposée au contact de la première couche 110a, 110b et de la deuxième couche 120a, 120b de l'îlot 100a, 100b considéré,
- Au moins un contact source 300 déposé sur la deuxième couche 120.

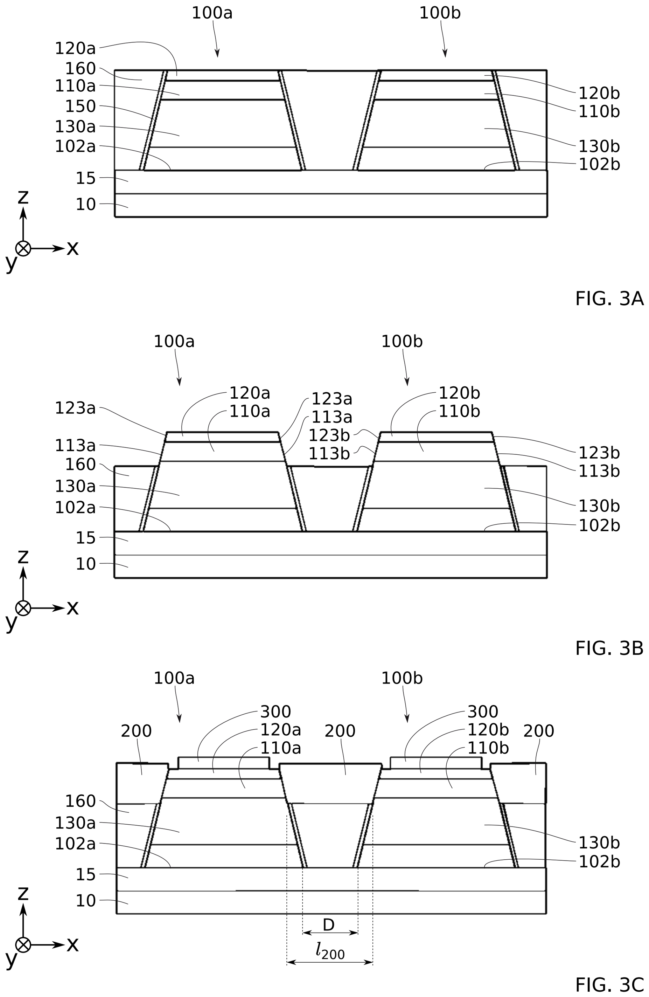

Un troisième mode de réalisation va maintenant être décrit en référence aux figures 3A à 3D.

Tout comme le premier mode de réalisation du procédé, ce mode de réalisation peut par exemple débuter avec la fourniture d'un substrat 10 et la formation par épitaxie localisée d'îlots 100a, 100b (figure 1A puis 1B correspondant à la figure 3A).

Les espaces entre îlots 100a, 100b sont là aussi remplis d'une couche de remplissage 160 diélectrique (figure 3A).

Comme illustré sur les figures 3A et 3B, la couche de remplissage 160 peut tout d'abord être formée jusqu'à hauteur des faces supérieures 101a, 101b des îlots 100a, 100b (figure 3A) puis être gravée de manière à ce que la couche de remplissage 160 se trouve en retrait selon la direction Z par rapport à la première couche 110a, 110b et à la deuxième couche 120a, 120b (figure 3B).

Selon un autre exemple, la couche de remplissage 160 est gravée sélectivement de manière à ce qu'elle se trouve en retrait selon la direction Z par rapport à la première couche 110a, 110b et à la deuxième couche 120a, 120b (figure 3B).

Dans les deux cas, comme illustré sur la figure 3B, les flancs externes 113a, 113b, 123a, 123b des première 113a, 123a et deuxième 113b, 123b couches se trouvent exposés.

Un motif électriquement conducteur ou grille 200 est ensuite déposé sur la couche remplissage 160. La grille 200 s'étend depuis les flancs externes 113a, 123a des première et deuxième couche 110a, 120a, d'un îlot 100a jusqu'aux flancs externes 113b, 123b des première et deuxième couche 110b, 120b, de l'îlot voisin 100b. Ainsi, dans ce mode de réalisation, la grille 200 est commune aux deux îlots voisins 100a, 100b.

Les flancs externes des îlots 100a, 100b étant inclinés, la largeur de la grille 200 est typiquement variable selon la direction Z. Cependant, l'inclinaison est relativement faible, et la largeur de la grille 200 se trouve en réalité être du même ordre de grandeur que la distance D séparant les îlots 100a, 100b.

Par simplification, on mesure la largeur I₂₀₀ de la grille 200 au niveau de sa face inférieure se trouvant en regard voire en contact de la couche de remplissage 160. La largeur I₂₀₀ est typiquement supérieure à 198µm, par exemple 199µm. La largeur I₂₀₀ est de préférence inférieure à 200 µm voire 199 µm.

Un contact source 300 est ensuite formé sur la deuxième couche 120a, 120b de chaque îlot 100a, 100b. Les contacts sources 300 sont propres à chaque îlot 100a, 100b.

On obtient ainsi l'empilement illustré à la figure 3C.

Les étapes de retrait du substrat 10 et de formation du drain 400 (figure 3D) sont réalisées de façon similaire à ce qui a été décrit en référence au premier mode de réalisation.

Le procédé permet ainsi de former au moins un transistor 1a, 1b, chacun formé des éléments suivants :
- Le drain 400, ou du moins une portion de ce drain 400,
- Un îlot 100a, 100b, comprenant des couches de GaN aux dopages distincts dont la première couche 110a, 110b et la deuxième couche 120a, 120b,
- Au moins une grille 200 déposée au contact des flancs latéraux 113a, 123a de la première couche 110a, 110b et des flancs latéraux 113b, 123b de la deuxième couche 120a, 120b de l'îlot 100a, 100b considéré,
- Un contact source 300 déposé sur la deuxième couche 120.

Les paragraphes ci-dessous visent à détailler le fonctionnement des transistors 1a, 1b obtenus par le procédé selon l'invention. Ces explications sont valables pour tous les modes de réalisation. Notamment, elles s'appliquent à chaque grille 200/contact source 300 dans le cas de transistors multi grilles tels qu'illustrés dans le premier et le deuxième mode de réalisation.

Lors que la ou les grille(s) 200 sont polarisées positivement relativement au(x) contact(s) source(s) 300, un canal d'électrons est formé au travers de la première couche 110a, 110b et de la deuxième couche 120a, 120b, contre la ou les grille(s) 200. Par exemple, dans le cas du troisième mode de réalisation, le canal d'électrons est formé à proximité voire au niveau des flancs externes 113a, 113b, 123a, 123b de ces couches 110a, 110b, 120a, 120b. Les électrons passent ensuite dans la couche de drift 130a, 130b puis dans le drain 400.

A l'inverse, lorsque la ou les grille(s) 200 sont polarisées négativement relativement au(x) contact(s) source(s) 300, il n'y a plus de canal d'électrons, la première couche 110a, 110b et la deuxième couche 120a, 120b forment une jonction PN et la couche de drift 130a, 130b se déplète.

Ainsi, au vu des différents modes de réalisation décrits ci-dessus, l'invention permet de fabriquer des transistors verticaux à base de GaN sans utiliser de substrat GaN, coûteux et souvent uniquement disponible dans de faibles dimensions.

L'invention n'est pas limitée aux modes de réalisations précédemment décrits et s'étend à tous les modes de réalisation couverts par l'invention.

## Revendications

1. Procédé de fabrication d'au moins un transistor vertical (1a, 1b) comprenant les étapes suivantes :
• fournir un substrat (10) présentant une face supérieure (11),
• réaliser une épitaxie localisée de nitrure de gallium (GaN) sur la face supérieure (11) du substrat (10), de sorte à former au moins un îlot (100a, 100b) à base de GaN, chaque îlot (100a, 100b) comprenant une première couche (110a, 110b) à base de GaN dopé d'un premier type pris parmi un dopage de type n et un dopage de type p, et une deuxième couche (120a, 120b) à base de GaN dopé de l'autre type surmontant directement la première couche (110a, 110b), chaque îlot (100a, 100b) présentant une face, dite inférieure (102a, 102b), tournée au regard de la face supérieure (11) du substrat (10),
• au niveau de chaque îlot (100a, 100b), former au moins une grille (200) en contact avec la première couche (110a, 110b) et avec la deuxième couche (120a, 120b), l'au moins une grille (200) comprenant un motif électriquement conducteur, et former au moins un contact électriquement conducteur dit contact source (300) au contact de la deuxième couche (120a, 120b),
• former une couche électriquement conductrice (400) formant un drain, le drain (400) étant relié électriquement à la face inférieure (102a, 102b) de chaque îlot (100a, 100b), formant ainsi au moins un transistor vertical (1a, 1b).

2. Procédé de fabrication selon la revendication précédente dans lequel le substrat (10) est à base de silicium.

3. Procédé de fabrication selon l'une quelconque des revendications précédentes dans lequel chaque îlot (100a, 100b) présente une hauteur h₁₀₀ supérieure ou égale à 10 µm, de préférence supérieure ou égale à 20 µm, h₁₀₀ étant mesurée dans une direction perpendiculaire à un plan (XY) dans lequel la face supérieure (11) du substrat (10) s'étend principalement.

4. Procédé de fabrication selon l'une quelconque des revendications précédentes dans lequel l'étape de formation du drain (400) comprend les étapes suivantes :
• après formation de l'au moins un îlot (100a, 100b), retirer le substrat (10), puis
• former le drain (400) contre la face inférieure (102a, 102b) de l'au moins un îlot (100a, 100b).

5. Procédé de fabrication selon l'une quelconque des revendications 1 à 3 dans lequel l'étape de formation du drain (400) comprend les étapes suivantes :
• pour chaque îlot (100a, 100b), former au moins une interconnexion métallique traversant le substrat (10) et débouchant sur ledit îlot (100a, 100b),
• former le drain (400) contre une face inférieure (12) du substrat (10) opposée à sa face supérieure (11), le drain (400) se trouvant en contact avec l'au moins une interconnexion métallique.

6. Procédé de fabrication selon l'une quelconque des revendications précédentes dans lequel la formation de l'au moins une grille (200) comprend les étapes suivantes :
• graver au moins une ouverture (20) s'étendant depuis la face supérieure (101a, 101b) de l'au moins un îlot (100a, 100b), l'ouverture traversant entièrement la deuxième couche (120a, 120b) et traversant au moins partiellement la première couche (110a, 110b),
• former l'au moins une grille (200) dans l'au moins une ouverture (20).

7. Procédé de fabrication selon l'une quelconque des revendications 1 à 5 dans lequel l'étape d'épitaxie comprend l'étape suivante :
• former par épitaxie la première couche (110a, 110b) et la deuxième couche (120a, 120b) au travers d'un masque (170), de manière à définir au moins une ouverture (20) s'étendant depuis une face supérieure (101a, 101b) de l'au moins un îlot (100a, 100b), l'ouverture (20) traversant la deuxième couche (120a, 120b) et traversant au moins partiellement la première couche (110a, 110b),
et dans lequel l'au moins une grille (200) est formée dans ladite au moins une ouverture (20).

8. Procédé de fabrication selon l'une quelconque des revendications précédentes dans lequel une pluralité de grilles (200) est formée au contact de la première couche (110a, 110b) et de la deuxième couche (120a, 120b) d'un même îlot (100a, 100b).

9. Procédé de fabrication selon la revendication précédente dans lequel une pluralité de contacts sources (300) est formée en contact de la deuxième couche (120a, 120b) et dans lequel, en projection dans un plan (XY) dans lequel la face supérieure (11) du substrat (10) s'étend principalement, les grilles (200) et les contacts sources (300) se trouvent en alternance.

10. Procédé de fabrication selon l'une quelconque des revendications 1 à 5 dans lequel au moins deux îlots (100a, 100b) et deux transistors (1a, 1b) sont formés, et dans lequel la grille (200) formée au niveau du premier îlot (100a) et celle formée au niveau du deuxième îlot (100b) sont en continuité électrique et forment une grille (200) commune aux deux transistors (1a, 1b).

11. Procédé de fabrication selon la revendication précédente dans lequel la grille (200) commune aux deux transistors (1a, 1b) s'étend entre un flanc latéral (103a) du premier îlot (100a) et un flanc latéral (103b) du deuxième îlot (100b).

12. Procédé de fabrication selon l'une quelconque des revendications précédentes dans lequel le drain (400) est à base de cuivre.

13. Procédé de fabrication selon la revendication 4 seule ou en combinaison avec l'une quelconque des revendications 6 à 12 dans lequel l'étape de retrait du substrat (10) est réalisée avant la formation de la grille (200) et de l'au moins un contact source (300) au niveau de chaque îlot (100a, 100b), et éventuellement avant la formation de la première couche (110a, 110b) et de la deuxième couche (120a, 120b).

14. Procédé de fabrication selon la revendication 4 seule ou en combinaison avec l'une quelconque des revendications 6 à 12 dans lequel l'étape de retrait du substrat (10) est réalisée après la formation de la grille (200) et de l'au moins un contact source (300) au niveau de chaque îlot (100a, 100b).
